**Europäisches Patentamt**

**European Patent Office**

**Office européen des brevets**

(19)

(11) Veröffentlichungsnummer: **0 005 808**
**B1**

(12)

# EUROPÄISCHE PATENTSCHRIFT

(45) Veröffentlichungstag der Patentschrift:
14.04.82

(51) Int. Cl.³: **H 04 L 3/00, H 03 K 13/25**

(21) Anmeldenummer: **79101610.8**

(22) Anmeldetag: **25.05.79**

(54) **Anordnung zur Erzeugung 2n-stufiger digitaler Signale aus n binären Signalen.**

(30) Priorität: **29.05.78 DE 2823383**

(43) Veröffentlichungstag der Anmeldung:
**12.12.79 Patentblatt 79/25**

(45) Bekanntmachung des Hinweises auf die Patenterteilung:
**14.04.82 Patentblatt 82/15**

(84) Benannte Vertragsstaaten:
**BE CH FR GB IT LU NL SE**

(56) Entgegenhaltungen:
**DE-A-1 437 584
DE-A-2 025 797
DE-B-1 802 611
GB-A-1 069 930
GB-A-1 250 492
GB-A-1 250 493
GB-A-1 489 861
US-A-3 753 113
US-A-3 882 485**

(73) Patentinhaber: **SIEMENS AKTIENGESELLSCHAFT Berlin
und München, Postfach 22 02 61, D-8000 München 22 (DE)**

(72) Erfinder: **Meyer, Fritz, Dr.-Ing., Sudetenstrasse 9,
D-8032 Gräfelfing (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG.

Anordnung zur Erzeugung $2^n$-stufiger digitaler Signale aus n binären Signalen

Die Erfindung betrifft eine Anordnung zur Erzeugung $2^n$-stufiger digitaler Signale aus n binären Signalen mit $n \geq 2$, die unter Gewichtung entsprechend ihrer stellenmässigen Bedeutung aufsummiert werden, mit Transistorverstärkern und einer Summierschaltung.

Solche Anordnungen müssen bei sehr hoher Bitrate arbeiten, worunter eine Bitrate von wenigstens einigen hundert Mbit/s verstanden werden soll.

Die optimale Nutzung der Kapazität eines Übertragungskanals erfordert eine Anpassung des zu übertragenden Signals an den Störabstand im Übertragungskanal und an dessen Bandbreite. Wird als Übertragungsmedium ein Koaxialkabel benutzt, dann ist die Streckendämpfung näherungsweise proportinal der Quadratwurzel aus der Signalfrequenz. Daraus ergibt sich, dass mit zunehmender Übertragungsbandbreite der verfügbare Störabstand ausserordentlich schnell abnimmt. Die optimale Ausnutzung eines Digitalsignals ist dann möglich, wenn dieses Signal nicht in binärer Form, sondern in Form eines Signals mit mehreren Amplitudenstufen, eines sogenannten Mehrstufensignals, übertragen wird. Die Stufenzahl wird dabei in der Regel so gewählt, dass die Kanalkapazität als Produkt aus dem resultierenden Störabstand und der Bandbreite ein Maximum wird.

Aus der US-PS 3 882 485 ist eine Summierschaltung bekannt, durch die aus n binären Signalen $2^n$-stufige Signale erzeugt werden. Dazu wird von einem Netzwerk gesteuert eine Multiplikation und damit eine Gewichtung vorgenommen, die aber nicht durch das Umschalten von Stromquellen erfolgt.

Aus der GB-PS 1 489 861 ist ein Decoder bekannt, der durch Differenzverstärker geschaltete Stromquellen zur Abgabe gleichgrosser Ströme enthält. Mit den Ausgängen der Differenzverstärker sind Emitteranschlüsse von Multi-Emitter-Transistoren verbunden, wobei jeder dieser Multi-Emitter-Transistoren als Diodenmatrix Verwendung findet.

Die Erzeugung der Mehrstufensignale erfolgt in der Regel aus binären Ursprungssignalen, beispielsweise mittels einer gewichteten Addition. Bei der gewichteten Addition von binären Signalen sehr hoher Bitrate treten besondere Schwierigkeiten hinsichtlich der exakten Gewichtung und einer rückwirkungsfreien Addition aufgrund von Anpassungsschwierigkeiten auf.

Die Aufgabe der Erfindung besteht darin, eine Schaltungsanordnung der eingangs erwähnten Art anzugeben, die sehr geringe Rückwirkungen auf die Eingangssignale mit einer möglichst exakten Gewichtung verbindet und eine allseitige Anpassung ermöglicht.

Erfindungsgemäss wird die Aufgabe dadurch gelöst, dass ein erster und ein zweiter Multi-Emitter-Transistor mit jeweils n Emitteranschlüssen vorgesehen sind, dass die Basisanschlüsse der Multi-Emitter-Transistoren miteinander und über einen Widerstand mit Bezugspotential verbunden sind, dass die Kollektoranschlüsse beider Multi-Emitter-Transistoren jeweils getrennt über weitere Widerstände mit Bezugspotential verbunden sind und dass der Kollektoranschluss des ersten Multi-Emitter-Transistors mit dem Ausgangsanschluss verbunden ist, dass die Emitteranschlüsse beider Multi-Emitter-Transistoren jeweils getrennt sowohl über eine Stromquelle mit Betriebsspannung als auch mit dem Ausgangsanschluss eines von n mit den Signaleingängen verbundenen Emitterfolgern verbunden sind, und zwar derart, dass der erste Emitteranschluss des ersten Multi-Emitter-Transistors sowohl mit einer Stromquelle verbunden ist, die einen Strom mit 1fachem Wert abgibt, als auch mit dem Emitteranschluss eines Emitterfolgers, dem das erste Eingangssignal zugeführt ist, und der erste Emitteranschluss des zweiten Multi-Emitter-Transistors sowohl mit einer Stromquelle, die einen Strom mit 1fachem Wert abgibt, als auch mit dem Emitteranschluss eines Emitterfolgers verbunden ist, dem das erste inverse Eingangssignal zugeführt ist, und die weiteren Emitteranschlüsse zwischen dem ersten und dem n-ten der beiden Multi-Emitter-Transistoren in entsprechender Weise mit den zugeordneten Emitterfolgern und Stromquellen verbunden sind und dabei die Stromquellen einen Strom mit einem nach Potenzen von 2 abgestuft vielfachen Wert abgeben, und der n-te Emitteranschluss des ersten Multi-Emitter-Transistors sowohl mit einer Stromquelle, die den $2^{n-1}$-fachen Strom abgibt, als auch mit dem Emitteranschluss eines Emitterfolgers verbunden ist, dem das n-te Eingangssignal zugeführt ist, und der n-te Emitteranschluss des zweiten Multi-Emitter-Transistors sowohl mit einer Stromquelle, die den $2^{n-1}$-fachen Strom abgibt, als auch mit dem Emitteranschluss eines Emitterfolgers verbunden ist, dessem Eingang das inverse n-te Eingangssignal zugeführt ist. Die erfindungsgemässe Schaltungsanordnung setzt sich in vorteilhafter Weise nur aus Transistoren und Widerständen, die ihrerseits wieder durch Transistorstrecken ersetzt werden können, zusammen. Damit ergibt sich die Möglichkeit, die Anordnung in integrierter Technik aufzubauen.

Ein vorteilhaft einfacher Aufbau unter Verzicht auf Transistor-Stromquellen ergibt sich dadurch, dass als Stromquellen ausreichend hochohmige Widerstände vorgesehen sind, deren Widerstandswerte nach Potenzen von 2 gestuft sind.

Zur Anpassung an die üblicherweise verwendeten Logikpegel ist eine Variante der Erfindung zweckmässig, bei der dem positiveren Potential der binären Eingangssignale der logische Einszustand zugeordnet ist.

Die Erfindung soll im folgenden anhand der Zeichnung näher erläutert werden. In der Zeichnung zeigt:

Fig. 1 eine Schaltungsanordnung zur Erzeugung

eines $2^n$-stufigen digitalen Signals aus n binären Eingangssignalen,

Fig. 2 die Erzeugung eines vierstufigen digitalen Signals aus zwei binären Eingangssignalen und

Fig. 3 ein Impulsdiagramm zu Fig. 2.

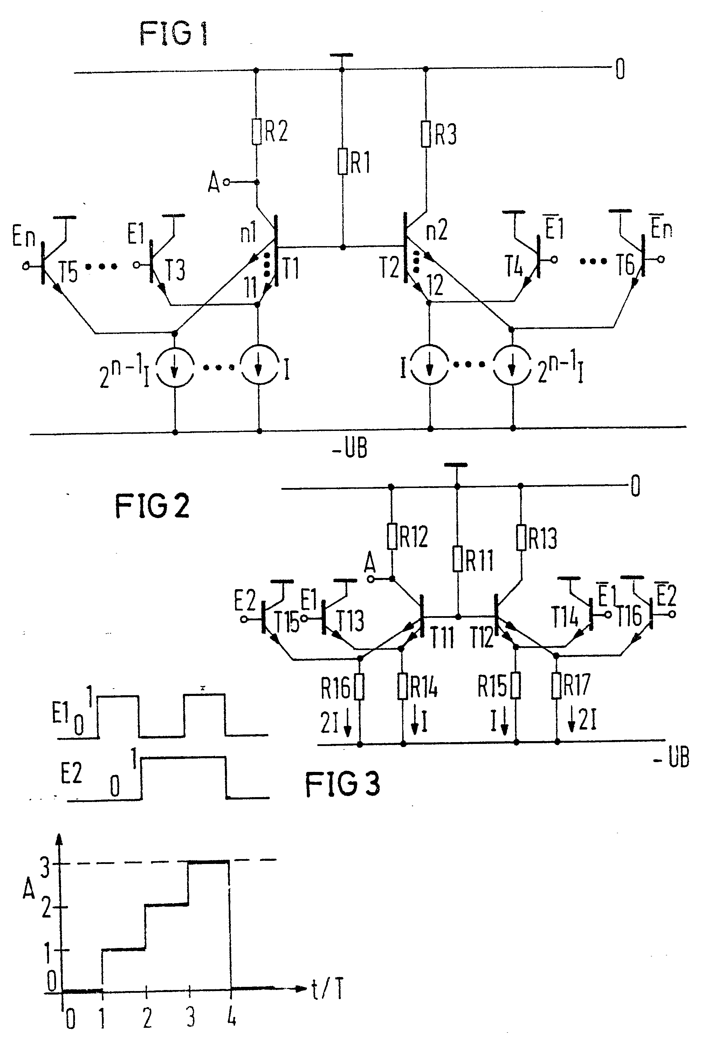

Die in der Fig. 1 dargestellte Anordnung zur Erzeugung $2^n$-stufiger Signale aus n binären Signalen enthält die beiden Multi-Emitter-Transistoren T1 und T2, deren Basisanschlüsse miteinander und über den Widerstand R1 mit Bezugspotential verbunden sind, während die Kollektoranschlüsse über die Widerstände R2 bzw. R3 an Bezugspotential angeschlossen sind. Die einzelnen Emitteranschlüsse der beiden Multi-Emitter-Transistoren sind über Stromquellen mit der Betriebsspannung -UB verbunden, so dass dieser Teil der Schaltung einen basisgekoppelten Differenzverstärker darstellt. Zusätzlich sind die Emitteranschlüsse der Multi-Emitter-Transistoren mit den Emitteranschlüssen vorgeschalteter Emitterfolger so verbunden, dass der aus dem Transistor T3 gebildete Emitterfolger, dessem Eingang das erste Eingangssignal E1 zugeführt ist, mit dem ersten Emitteranschluss 11 des ersten Multi-Emitter-Transistors T1 verbunden ist. Die an den Emitteranschluss 11 angeschlossene Stromquelle liefert einen Strom I bestimmter Grösse. Mit dem ersten Emitteranschluss 12 des zweiten Multi-Emitter-Transistors T2 ist ebenfalls eine Quelle für den Strom I und der Emitteranschluss eines vorgeschalteten, aus dem Transistor T4 gebildeten Emitterfolgers verbunden, dem aber das Eingangssignal Ē zugeführt wird. In entsprechenger Weise sind die weiteren Emitteranschlüsse der Multi-Emitter-Transistoren T1 und T2 über Emitterfolger mit Eingangsanschlüssen für das zweite, das zweite inverse und weitere Eingangssignale verbunden und ausserdem über Stromquellen, die den doppelten bzw. vierfachen Strom abgeben, an die negative Betriebsspannung -UB angeschlossen. Schliesslich ist der n-te Emitteranschluss n1 des ersten Multi-Emitter-Transistors T1 über eine Stromquelle für den $2^{n-1}$-fachen Strom I mit der Betriebsspannung -UB verbunden und erhält über den aus dem Transistor T5 gebildeten Emitterfolger das n-te Eingangssignal En. In entsprechender Weise erhält der n-te Emitteranschluss n2 des zweiten Multi-Emitter-Transistors T2 von einer mit der Betriebsspannung -UB verbundenen Stromquelle den $2^{n-1}$-fachen Strom und über den aus dem Transistor T6 gebildeten weiteren Emitterfolger das inverse n-te Eingangssignal Ēn. Durch die mit den Emitteranschlüssen verbundenen Stromquellen ergibt sich eine nach Potenzen von 2 abgestufte Gewichtung der Eingangssignale; das erste Eingangssignal wird also mit dem $2^0$-fachen Strom, das n-te Eingangssignal mit dem $2^{n-1}$-fachen Strom gewichtet. Die gewichteten Emitterströme der beiden Multi-Emitter-Transistoren erscheinen, um den praktisch zu vernachlässigenden Basisstromanteil verringert, am jeweiligen Kollektoranschluss.

In der Fig. 2 ist eine Anordnung nach der Fig. 1 für die Verknüpfung zweier binärer Eingangssignale zu einem vierstufigen Ausgangssignal, das als Sendesignal an den Eingang einer Koaxial-Kabelstrecke abgegeben werden kann, dargestellt. Die Schaltungsanordnung enthält zwei nach Art eines basisgekoppelten Differenzverstärkers zusammengeschaltete Multi-Emitter-Transistoren T11 und T12 sowie vier den Emitteranschlüssen der beiden Multi-Emitter-Transistoren vorgeschaltete Emitterfolger, die durch die Transistoren T13, T15 und T 14, T 16 gebildet sind. Die Anordnung entspricht damit in ihrem Aufbau der der Fig. 1, es sind lediglich die mit den Emitteranschlüssen der Multi-Emitter-Transistoren verbundenen Stromquellen durch entsprechend bemessene Widerstände R14, R16 und R15, R17 ersetzt. In der praktischen Ausführung weisen die Widerstände R14 und R15 Widerstandswerte von jeweils 200 Ohm, die Widerstände R16 und R17 Widerstandswerte von 100 Ohm auf, so dass sich entsprechende Emitterströme von I bzw. 2I ergeben. Zur Anpassung an das nachgeschaltete Kabel wurde der Widerstand R12 und auch der Widerstand R13 zu je 75 Ohm gewählt, der Wert des Widerstandes R11 ergab sich zu 8,7 kOhm.

Mit Hilfe des Impulsdiagramms nach der Fig. 3 sei die Erzeugung eines vierstufigen Sendesignals aus zwei binären Signalen E1 und E2 und deren inversen Signalen Ē1 und Ē2 kurz erläutert. Dabei wird vorausgesetzt, dass dem positiveren Potential in den binären Eingangssignalen der logische Einszustand entspricht. Das vierstufige Sendesignal kann die Werte 0, 1, 2 und 3 annehmen, wobei dem höheren Wert jeweils auch das positivere Potential zugeordnet ist. Im vorliegenden Falle ergibt sich für den Wert 3 in der Fig. 3 eine Spannung von 0 Volt, die Werte 2, 1 und 0 werden durch negativere Potentiale dargestellt.

Für die Erläuterung der Funktion sei zunächst angenommen, dass beide Eingangssignale E1 und E2 im logischen Nullzustand sind. Damit sind beide Emitter des ersten Multi-Emitter-Transistors auf vergleichsweise negativem Potential, so dass beide Emitter des ersten Multi-Emitter-Transistors T11 leiten, während beide Emitter des zweiten Multi-Emitter-Transistors T12 gesperrt sind. Die am Kollektor des Multi-Emitter-Transistors T11 addierten Ströme stellen den maximalen Strom durch diesen Transistor dar, am Kollektorwiderstand R12 wird das niedrigste Potential erzeugt, das dem Wert logisch Null entspricht.

Ändert sich nun der Pegel im Eingangssignal E1 auf den logischen Einswert, dann wird der kleinere der beiden Emitterströme des Multi-Emitter-Transistors T11 gesperrt. Am Kollektor dieses Transistors entsteht dann ein positiveres Potential, das dem Wert logisch Eins entspricht. Ausserdem leitet nun aber ein Emitter des Multi-Emitter-Transistors T12, da Ē1 auf dem Wert logisch Null ist. Dem Strom I zugeordnete Ladungen in der Basiszone des Transistors T11 werden bei diesem Umschaltvorgang direkt in die Basiszone des Transistors T12 übertragen, so dass sich dadurch ein sehr schnelles Umschalten des Stromes von einem Emitter des Transistors T11 auf den entsprechenden Emitter des Transistors T12 ergibt. Die sehr schnelle Umschaltung der Emitterströme ergibt sich auch dadurch, dass eine Sättigung der Transistoren vermieden wird.

Ist nach einer Umschaltung der Eingangssignale das erste Eingangssignal E1 auf dem Wert logisch Null und das zweite Eingangssignal E1 auf dem Wert logisch Eins, dann wird der grössere Emitterstrom vom Transistor T11 auf den Transistor T12 übertragen. Das Potential am Kollektor des Transistors T11 wird nun gegenüber dem vorangegangenen Fall positiver, es ergibt sich der Wert logisch Zwei im Ausgangssignal.

Sind abschliessend beide Eingangssignale auf dem Wert logisch Eins, dann ist der Transistor T11 völlig gesperrt und das Potential am Kollektoranschluss dieses Transistors hat nun seinen positivsten Wert; dies entspricht im Ausgangssignal dem Wert logisch Drei.

Zum Ausgleich der unterschiedlichen Verstärkungseigenschaften bei nicht speziell ausgesuchten Multi-Emitter-Transistoren ist es möglich, zusätzlich die als Stromquellen dienenden Emitterwiderstände zu verringern bzw. zu vergrössern. Zur Ansteuerung weiterer symmetrischer Differenzverstärker ist es ausserdem möglich, vom Kollektoranschluss des zweiten Multi-Emitter-Transistors das inverse Ausgangssignal zu entnehmen.

**Patentansprüche**

1. Anordnung zur Erzeugung $2^n$-stufiger digitaler Signale aus n binären Signalen mit n ≥ 2, die unter Gewichtung entsprechend ihrer stellenmässigen Bedeutung aufsummiert werden, mit Transistorverstärkern und einer Summierschaltung, dadurch gekennzeichnet, dass ein erster und ein zweiter Multi-Emitter-Transistor (T1, T2; T11, T12) mit jeweils n Emitteranschlüssen (11...n1, 12...n2) vorgesehen sind, dass die Basisanschlüsse der Multi-Emitter-Transistoren miteinander und über einen Widerstand (R1; R11) mit Bezugspotential (0) verbunden sind, dass die Kollektoranschlüsse beider Multi-Emitter-Transistoren jeweils getrennt über weitere Widerstände (R2, R3; R12, R13) mit Bezugspotential (0) verbunden sind und dass der Kollektoranschluss des ersten Multi-Emitter-Transistors (T1; T11) mit dem Ausgangsanschluss (A) verbunden ist, dass die Emitteranschlüsse beider Multi-Emitter-Transistoren jeweils getrennt sowohl über eine Stromquelle mit Betriebsspannung (-UB) als auch mit dem Ausgangsanschluss eines von n mit den Signaleingängen verbundenen Emitterfolgern (T3, T5, T4, T6; T13, T15, T14, T16) verbunden sind, und zwar derart, dass der erste Emitteranschluss (11) des ersten Multi-Emitter-Transistors (T1; T11) sowohl mit einer Stromquelle verbunden ist, die einen Strom mit 1fachem Wert abgibt, als auch mit dem Emitteranschluss eines Emitterfolgers (T3; T13), dem das erste Eingangssignal (E1) zugeführt ist, und der erste Emitteranschluss (12) des zweiten Multi-Emitter-Transistors (T2; T12) sowohl mit einer Stromquelle, die einen Strom mit 1fachem Wert abgibt, als auch mit dem Emitteranschluss eines Emitterfolgers (T4; T14) verbunden ist, dem das erste inverse Eingangssignal (E1) zugeführt ist, und die weiteren Emitteranschlüsse zwischen dem ersten und dem n-ten der beiden Multi-Emitter-Transistoren in entsprechender Weise mit den zugeordneten Emitterfolgern und Stromquellen verbunden sind und dabei die Stromquellen einen Strom mit einem nach Potenzen von 2 abgestuft vielfachen Wert abgeben, und der n-te Emitteranschluss (n1) des ersten Multi-Emitter-Transistors (T1; T11) sowohl mit einer Stromquelle, die den $2^{n-1}$-fachen Strom abgibt, als auch mit dem Emitteranschluss eines Emitterfolgers (T5; T15) verbunden ist, dem das n-te Eingangssignal (En) zugeführt ist, und der n-te Emitteranschluss (n2) des zweiten Multi-Emitter-Transistors (T2; T12) sowohl mit einer Stromquelle, die den $2^{n-1}$-fachen Strom abgibt, als auch mit dem Emitteranschluss eines Emitterfolgers (T6; T16) verbunden ist, dessen Eingang das inverse n-te Eingangssignal (En) zugeführt ist.

2. Anordnung nach Anspruch 1, dadurch gekennzeichnet, dass als Stromquellen ausreichend hochohmige Widerstände (R14, R16; R15, R17) vorgesehen sind, deren Widerstandswerte nach Potenzen von 2 gestuft sind.

3. Anordnung nach Anspruch 1, dadurch gekennzeichnet, dass dem positiveren Potential der binären Eingangssignale (E1, En) der logische Einszustand zugeordnet ist.

**Claims**

1. An arrangement for the generation of $2^n$-stage digital signals which consist of n binary signals, where n ≥ 2, and which are summed up by weighting in accordance with the significance of their position, comprising transistor amplifiers an a summation circuit, characterised in that there are provided first and second multi-emitter transistors (T1, T2; T11, T12), each having n emitter electrodes (11...n1, 12...n2), that the base electrodes of the multi-emitter transistors are mutually connected together and to a point of reference potential (0) via a common resistor (R1; R11), that the collector electrodes of the two multi-emitter transistors are individually connected via respective further resistors (R2, R3, R12, R13) to the point of reference potential (0), and that the collector electrode of the first multi-emitter transistor (T1, T11) is connected to the output terminal (A), that the emitter electrodes of the two multi-emitter transistors are individually connected to the operating voltage (-UB), via a respective current source, and also to the output terminal of a respective one of n emitter followers (T3, T5, T4, T6, T13, T15, T14, T16) that are connected to the signal inputs, in such manner that the first emitter electrode (11) of the first multi-emitter transistor (T1, T11) is connected both to a current source which emits a current having a value which is multiplied by 1, and to the emitter electrode of an emitter follower (T3, T13) to which the first input signal (E1) is fed, and the first emitter electrode (12) of the second multi-emitter transistor (T2; T12) is connected both to a current source which emits a current having a value which is multiplied by 1, and to the emitter electrode of an emitter follower (T4; T14) to which the first inverse input signal (E1) is fed, and the further emitter electrodes between the first and the n-th of the two multi-emitter transistors are correspondingly connected to the assigned emitter followers and current sources and the current sources emit a current having a multiple value which is graded in accordance with powers of 2, the n-th emitter electrode (n1) of the first multi-emitter transistor (T1; T11) being connected both to a current source which emits the current multiplied by $2^{n-1}$, and to the emitter electrode of an emitter follower (T5; T15) to which the n-th input signal (En) is fed, and the n-th emitter terminal (n2) of the second multi-emitter transistor (T2; T12) connected both to a current source which emits the current multiplied by $2^{n-1}$, and to the emitter electrode of an emitter follower (T6, T16) to whose input the n-th inverse input signal (En) is fed.

2. An arrangement as claimed in Claim 1, characterised in that resistors (R14, R16; R15, R17), whose resistance values are sufficiently high and are graded in accordance with powers of 2, are provided to serve as current sources.

3. An arrangement as claimed in Claim 1, characterised in that the more positive potential of the binary input signals (E1, En) is assigned the logic "one"-state.

## Revendications

1. Dispositif pour produire des signaux numériques à $2^n$ niveaux à partir de n signaux binaires, avec $n \geq 2$ qui sont totalisés avec pondération suivant leur importance du point de vue de leurs positions, du type comportant des amplificateurs à transistors et un circuit de totalisation, caractérisé par le fait qu'il est prévu un premier et un second transistors multi-émetteur (T1, T2; T11, T12) ayant chacun un contact d'émetteur (11...n1, 12...n2), que les contacts de base du transistor multi-émetteur sont reliés entre eux et, par l'intermédiaire d'une résistance (R1, R11), à un potentiel de référence (0), que les contacts de collecteur des deux transistors multi-émetteur sont séparément reliés par l'intermédiaire d'une résistance (R2, R3; R12, R13), au potentiel de référence (0) et que le contact de collecteur du premier transistor multi-émetteur (T1, T11) est relié à la borne de sortie (A), que les contacts d'émetteur des deux transistors multi-émetteur sont reliés séparément tant par l'intermédiaire d'une source de courant à la tension de service (-UB) qu'à la borne de sortie d'un parmi n transistors à émetteurs-suiveurs (T3, T5, T4, T6; T12, T15, T14, T16) reliés aux entrées des signaux, et cela de telle manière que le premier contact d'émetteur (11) du premier transistor multi-émetteur (T1, T11) est relié aussi bien à une source de courant fournissant un courant de valeur unitaire qu'au contact d'émetteur de l'émetteur-suiveur (T3; T13) auquel est appliqué le premier signal d'entrée (E1), que le premier contact d'émetteur (12) du second transistor multi-émetteur (T2; T12) est relié tant à une source de courant fournissant un courant de valeur unitaire qu'au contact émetteur d'un émetteur-suiveur (T4; T14) auquel est appliqué le premier signal d'entrée inverse (E1), que les autres contacts d'émetteur entre le premier et le n-ième des deux transistors multi-émetteur sont reliés de façon correspondante aux émetteurs-suiveurs et aux sources de courant associés, des sources de courant fournissant un courant de valeurs multiples à des niveaux des puissances de 2, que le n-ième contact émetteur (n1) du premier transistor multi-émetteur (T1; T11) est relié à une source de courant qui donne un courant égal à $2^{n-1}$ fois le courant unitaire ainsi qu'au contact d'émetteur d'un émetteur-suiveur (T5; T15) auquel est appliqué le même signal d'entrée (En), et que le n-ième contact d'émetteur (n2) du second transistor multi-émetteur (T2; T12) est relié à une source de courant qui fournit un courant égal à $2^{n-1}$ fois le courant unitaire et au contact d'émetteur d'un émetteur-suiveur (T6; T16) dont l'entrée reçoit le n-ième signal d'entrée inverse (En).

2. Dispositif selon la revendication 1, caractérisé par le fait que l'on prévoit comme sources de courant, des résistances (R14, R16; R15, R17) de valeurs ohmiques suffisamment élevées, les valeurs des résistances se situant à des niveaux qui sont égaux à des puissances de 2.

3. Dispositif selon la revendication 1, caractérisé par le fait que l'état logique (UN) est associé au potentiel le plus positif des signaux d'entrée binaires (E1, En).

FIG 1

FIG 2

FIG 3

0 005 808

7